Europäisches Patentamt

European Patent Office

Office européen des brevets

(11) Publication number: 0 645 640 A1

# EUROPEAN PATENT APPLICATION

(21) Application number: 94103853.1

(51) Int. Cl.6: **G01R 33/383**, G01R 33/44

(22) Date of filing: 12.03.94

(30) Priority: 29.09.93 JP 277274/93
21.12.93 JP 322307/93

(43) Date of publication of application:
29.03.95 Bulletin 95/13

(84) Designated Contracting States:
AT BE CH DE DK ES FR GB GR IE IT LI LU MC NL PT SE

(71) Applicant: Fujimoto, Shigenobu
188, Oaza-Yuritani,
Miwa-cho
Kuga-gun,
Yamaguchi 740-12 (JP)
Applicant: Bozono, Hiroyuki
7-27-1007, Hakushima-nakamachi,
Naka-ku
Hiroshima-shi,
Hiroshima 730 (JP)
Applicant: Nakatani, Yutaka
3-9-3-811, Koihonmachi,
Nishi-ku
Hiroshima-shi,
Hiroshima 736 (JP)

(72) Inventor: Fujimoto, Shigenobu
188, Oaza-Yuritani,
Miwa-cho
Kuga-gun,
Yamaguchi 740-12 (JP)
Inventor: Bozono, Hiroyuki
7-27-1007, Hakushima-nakamachi,
Naka-ku
Hiroshima-shi,
Hiroshima 730 (JP)
Inventor: Nakatani, Yutaka
3-9-3-811, Koihonmachi,
Nishi-ku
Hiroshima-shi,
Hiroshima 736 (JP)

(74) Representative: Selting, Günther et al
Patentanwälte
von Kreisler-Selting-Werner,
Bahnhofsvorplatz 1 (Deichmannhaus)
D-50667 Köln (DE)

(54) Magnetic field sweeping apparatus and magnetic resonance apparatus.

(57) A magnetic field sweeping apparatus which deals with chemical shift during magnetic resonance of a moving object material, wherein static magnetic field generated in an open section of a magnetic path through which the object material moves is formed to have magnetic force of gradient distribution, capable of capturing the static magnetic field automatically within the resonance zone for the chemical shift of the magnetic resonance without converting the frequency of the high frequency electromagnetic field to be applied. A magnetic resonance apparatus employing the magnetic field sweeping apparatus which causes magnetic resonance such as nuclear magnetic resonance and electron spin resonance in the object material such as hydrogen compounds.

Fig. 1

Rank Xerox (UK) Business Services
(3.10/3.09/3.3.4)

## BACKGROUND OF THE INVENTION

### Field of the invention

The present invention relates to a magnetic resonance apparatus to generate magnetic resonance such as nuclear magnetic resonance and electron spin resonance, and particularly to a magnetic field sweeping apparatus capable of dealing with chemical shift which takes place during the magnetic resonance.

### Description of Related Art

In magnetic resonance such as nuclear magnetic resonance or electron spin resonance wherein a specimen material undergoes resonance and absorbs electromagnetic radiation energy upon application of a high frequency electromagnetic field which corresponds to the energy difference between two energy levels of atoms constituting the specimen placed in a static magnetic field, measurement of the frequency where the atom absorbs the radiation or the spectrum of absorbed radiation provides information on the electron density of the atom and the bond between atoms. This phenomenon of magnetic resonance has been utilized in the researches on the properties of inorganic materials and researches on radicals of organic compounds, making great contributions to the recent advancements in such fields as solid state physics, complex chemistry, organic electron research, radiation chemistry, photochemistry and electrochemistry.

A mechanism to increase a function of separating impurities included in water and thereby to improve the purifying function by causing magnetic resonance in hydrogen atoms of water which is a compound of hydrogen, thereby to increase the energy level and acting on hydrogen bond or covalent bond, and an attempt to improve combustion efficiency by causing magnetic resonance in hydrogen atoms of hydrocarbon which is a covalently bonded molecule thereby to increase the energy level and accelerate the dissociation of hydrocarbon molecules have been proposed by the present applicant.

As for the nuclear magnetic resonance, for example, it has been known that a hydrogen nucleus placed in a static magnetic field of 14,092 gauss [G] shows nuclear magnetic resonance in response to the application of a high frequency electromagnetic field of 60 mega hertz [MHz], since American physicist Dr. Rabi published his discovery in 1932. Intensity G of the static magnetic field and frequency N of the high frequency electromagnetic radiation which cause the nuclear magnetic resonance in hydrogen nuclei are associated by the following relationship.

$$G/g = N$$

where G: Intensity of static magnetic field [G]
g: Resonance constant (234.87 for hydrogen) [G/MHz]
N: Frequency of high frequency electromagnetic radiation [MHz]

Because of chemical shift in the nuclear magnetic resonance, the frequency N of the high frequency electromagnetic radiation is shifted to $N \pm \eta$ ($\eta$ : sweep frequency for chemical shift [MHz]) when the static magnetic field intensity G is kept constant, or intensity G of the static magnetic field is shifted to $G \pm \sigma$ ($\sigma$ : sweep magnetic field for chemical shift [G]) when the frequency N of the high frequency electromagnetic radiation is kept constant.

Chemical shift in the nuclear magnetic resonance has been dealt with in the prior art by sweeping the frequency of the high frequency electromagnetic radiation by means of a frequency conversion amplifier to sweep the frequency of high frequency electromagnetic radiation while keeping the static magnetic field intensity constant.

This sweeping method for the chemical shift of the prior art has drawbacks of the complex constitution of the frequency conversion amplifier and being expensive. Also there is a problem that automatic sweeping cannot be done continuously unless the radiation frequency is swept manually with the chemical shift being estimated beforehand.

## SUMMARY OF THE INVENTION

Major object of the invention is to provide a magnetic field sweeping apparatus capable of automatically dealing with the chemical shift during magnetic resonance in a simple constitution, thereby automatically carrying out stable magnetic resonance continuously, and a magnetic resonance apparatus using the magnetic field sweeping apparatus.

Another object of the invention is to provide a magnetic field sweeping apparatus capable of automatically dealing with the chemical shift in the magnetic resonance without using an expensive frequency conversion amplifier, and a magnetic resonance apparatus using the magnetic field sweeping apparatus.

The magnetic field sweeping apparatus of the invention is a magnetic field sweeping apparatus to deal with the chemical shift which occurs when a moving object material is put in magnetic resonance, and forms a magnetic field having gradient distribution of magnetic force in an opening of a magnetic path wherein the object material moves.

By changing the configuration of the portion where a strong magnetic field is generated to put the object material in magnetic resonance, namely the open section of the magnetic path of the magnetic circuit along the direction of the movement of the object material, the magnetic field is made to have gradient intensity distribution in the direction of the movement of the object material in the open section of the magnetic path of the magnetic circuit. This arrangement causes a portion, where the magnetic field intensity matches the chemical shift according to the equation described previously, to exist in at least one place in the open section of the magnetic path of the magnetic circuit, even when the frequency of the high frequency electromagnetic radiation is kept constant, thereby stable magnetic resonance can be obtained in the object material.

Gradience of the magnetic force of the static magnetic field may be obtained by opening the magnetic field gradually from the upstream to the downstream of the object material movement, by closing the magnetic field gradually from the upstream to the downstream of the object material movement, or by opening the magnetic field gradually from the upstream position toward the center and closing it gradually from the center to the downstream of the object material movement.

In order to achieve such a gradient magnetic force distribution of the static magnetic field, width of the open section of the magnetic path of the magnetic circuit is changed along the moving direction of the object material, or thickness of the magnetic circuit which forms the magnetic path is changed along the moving direction of the object material.

The magnetic resonance apparatus of the invention employs the magnetic field sweeping apparatus as described above to put a moving object material in magnetic resonance, and is provided with a yoke to form a static magnetic field with the intensity thereof changing in the direction of the moving direction of the object material, and a low cost high frequency oscillating amplifier to apply high frequency electromagnetic field of a specified frequency to the object material.

The above and further objects and features of the invention will more fully be apparent from the following detailed description with accompanying drawings.

## BRIEF DESCRIPTION OF THE DRAWINGS

Fig.1 is an oblique view drawing illustrative of the overall construction of a magnetic resonance apparatus of the invention which causes magnetic resonance.

Fig.2 is a front view drawing illustrative of the overall construction of the magnetic resonance apparatus of the invention which causes magnetic resonance.

Fig.3 is an oblique view drawing illustrative of a key portion of a magnetic field sweeping apparatus of the first embodiment of the invention.

Fig.4 is a side view drawing in the direction of A-A line in Fig.2 illustrative of a key portion of the magnetic field sweeping apparatus of the first embodiment of the invention.

Fig.5 is an oblique view drawing illustrative of a key portion of a magnetic field sweeping apparatus of the second embodiment of the invention.

Fig.6 is a plan view drawing in the direction of B-B line in Fig.2 illustrative of a key portion of the magnetic field sweeping apparatus of the second embodiment of the invention.

Fig.7 is an oblique view drawing illustrative of a key portion of a magnetic field sweeping apparatus of the third embodiment of the invention.

Fig.8 is a plan view drawing in the direction of B-B line in Fig.2 illustrative of a key portion of the magnetic field sweeping apparatus of the third embodiment of the invention.

Fig.9 is an oblique view drawing illustrative of a key portion of a magnetic field sweeping apparatus of the fourth embodiment of the invention.

Fig.10 is a side view drawing in the direction of A-A line in Fig.2 illustrative of a key portion of the magnetic field sweeping apparatus of the fourth embodiment of the invention.

## DESCRIPTION OF THE PREFERRED EMBODIMENT

Now the invention will be described in detail with reference to the drawings illustrative of the preferred embodiments.

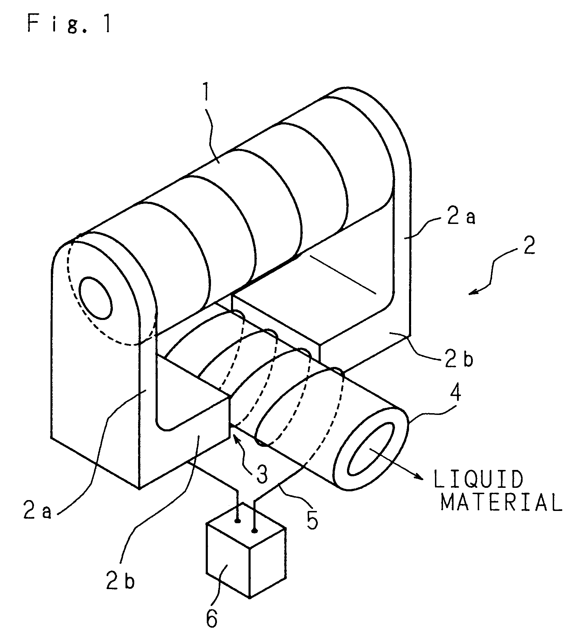

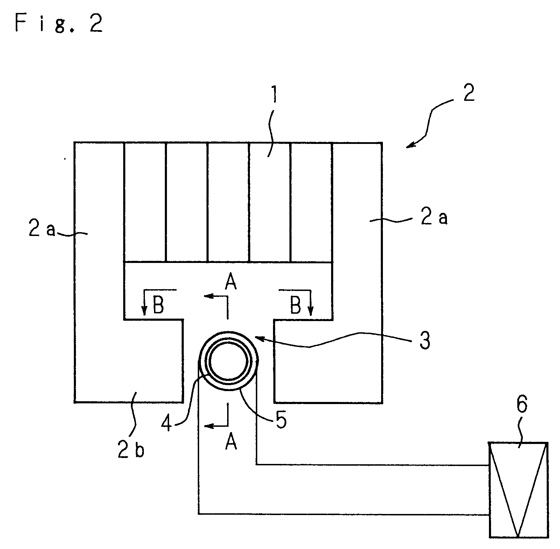

Fig.1 is an oblique view drawing illustrative of the construction of a magnetic resonance apparatus of the invention, and Fig.2 is a plan view thereof. In the drawings, numeral 1 denotes a magnet composed of an electromagnet or a permanent magnet, and the magnet 1 is provided with a yoke 2 being connected to both ends thereof to form a magnetic path. A part of the yoke 2 is cut away to form an open section 3 of the magnetic path. The yoke 2 has yoke bodies 2a connected to the magnet 1 and end portions 2b of the yoke (magnetic lens) being made in various configurations, which will be described in detail later, having N and S poles opposing each other being separated by the open section 3 of the magnetic path. A cylindrical pipe 4 is arranged to pass through the open section 3 of the magnetic path in the direction perpendicular to the magnetic field in the open section 3 of the magnetic path. The pipe 4 is made of a nonmetallic material which is not sensitive to magnetic effect, ceramics for example, not of a ferromagnetic material. The pipe 4 carries a hydrocarbon liquid material flowing therein in the direction indicated by an arrow in Fig.1, so that the liquid material flows through the magnetic field formed at the yoke end sections 2b from the magnet 1 via the yoke bodies 2a. The circumference of the pipe 4 is provided with a high frequency coil 5 wound around thereof which is connected to a high frequency oscillating amplifier 6 generating a constant high frequency electromagnetic wave, thereby to apply high frequency electromagnetic field to the inside of the pipe 4.

With such a constitution as described above, a static magnetic field and a high frequency electromagnetic field are formed and a hydrocarbon liquid material is made to flow in the pipe 4. According to the invention, frequency of the high frequency electromagnetic field applied by the high frequency oscillating amplifier 6 is constant, while intensity of the static magnetic field is swept. When the static magnetic field has a proper intensity satisfying the equation for the chemical shift described previously, hydrogen nuclei included in the hydrocarbon liquid material flowing in the pipe 4 undergo nuclear magnetic resonance, resulting in increased dissociation of the hydrocarbon. The hydrocarbon liquid material with enhanced dissociation, namely improved combustion efficiency, is supplied to the downstream through the pipe 4.

The magnetic field sweeping apparatus of the invention has features in the configuration and arrangement of the yoke end sections 2b facing the open section 3 of the magnetic path to carry out magnetic field sweeping of the static magnetic field. Examples of patterns of the yoke end sections 2b to carry out magnetic field sweeping of the static magnetic field will be described below.

Embodiment 1

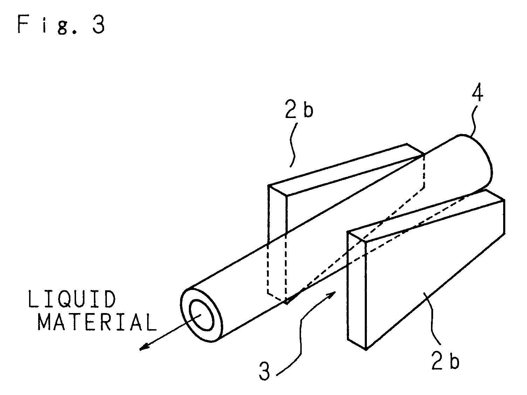

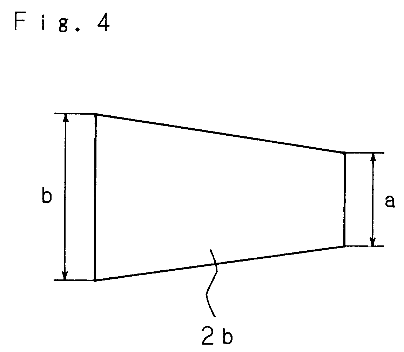

Fig.3 is an enlarged oblique view drawing illustrative of a pattern (first embodiment) of the invention. Fig.4 is a side view drawing in A-A line of Fig.2. In Fig.3, the arrow shows the direction of liquid material flow in the pipe 4. In the first embodiment, distance between the yoke end section 2b and the pipe 4 is constant from the upstream of the liquid material path in the pipe 4 (referred to simply as upstream hereinafter) to the downstream of the liquid material path in the pipe 4 (referred to simply as downstream hereinafter), although height of the yoke end section 2b is made to gradually increase so that the magnetic field has the maximum intensity at point a at the upstream end and decreases therefrom to point b at the downstream end.

Embodiment 2

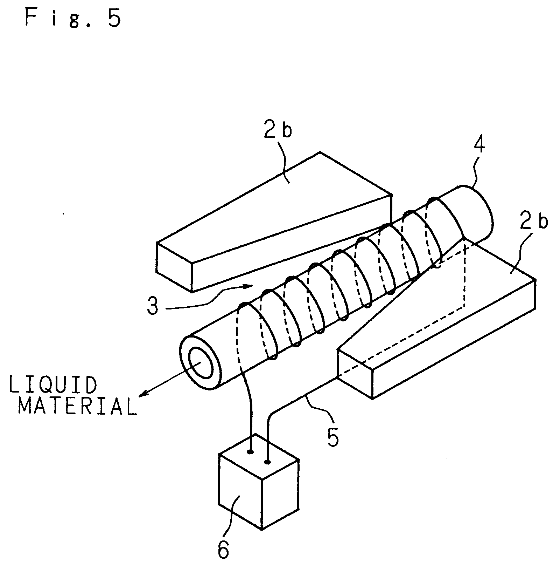

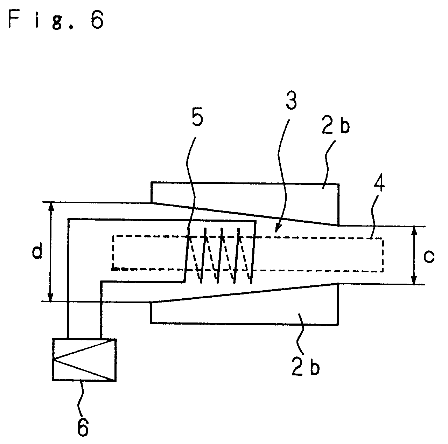

Fig.5 is an enlarged oblique view drawing illustrative of another pattern (second embodiment) of the invention. Fig.6 is a plan view drawing in B-B line of Fig.2. In Fig.5, the arrow shows the direction of liquid material flow in the pipe 4. In the second embodiment, because distance between the yoke end section 2b and the pipe 4 is made to gradually increase from the upstream to the downstream so that the length of the yoke end section 2b in the direction of the magnetic field gradually decreases, the magnetic field has the maximum intensity at point c at the upstream end, and decreases therefrom to point d at the downstream end.

Embodiment 3

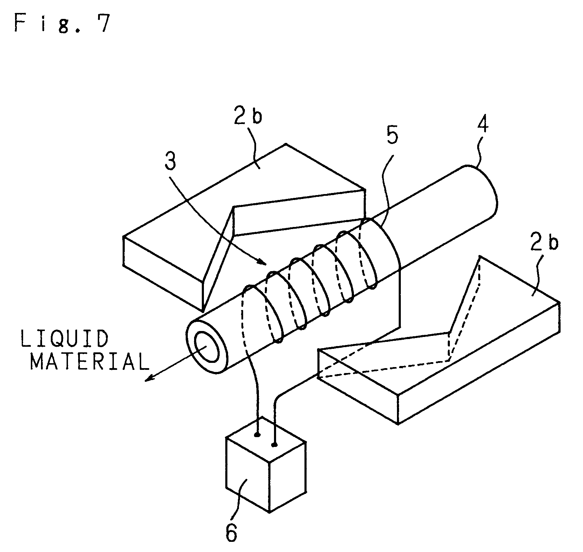

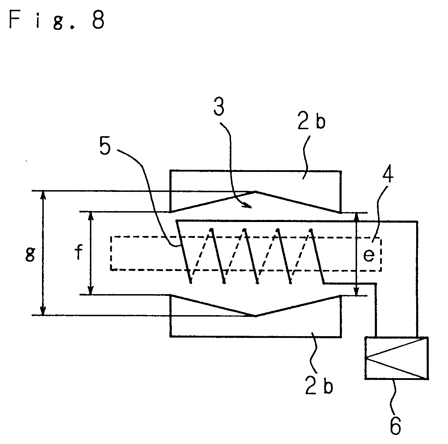

Fig.7 is an enlarged oblique view drawing illustrative of further another pattern (third embodiment) of the invention. Fig.8 is a plan view drawing in B-B line of Fig.2. In Fig.7, the arrow shows the direction of liquid material flow in the pipe 4. In the third embodiment, because distance between the yoke end section 2b and the pipe 4 is made to gradually increase from the upstream to the center so that the length of the yoke end section 2b in the direction of the magnetic field gradually decreases, and distance between the yoke end section 2b and the pipe 4 is made to gradually decrease from the center to the downstream so that the length of the yoke end section 2b in the direction of the magnetic field gradually increases, the magnetic field has the maximum intensity at point e at the upstream end and point f at the downstream end, and decreases therefrom toward the center, having a minimum intensity at point g at the center.

Embodiment 4

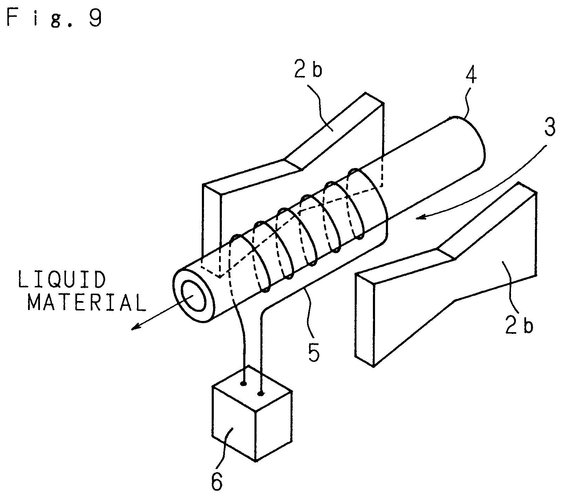

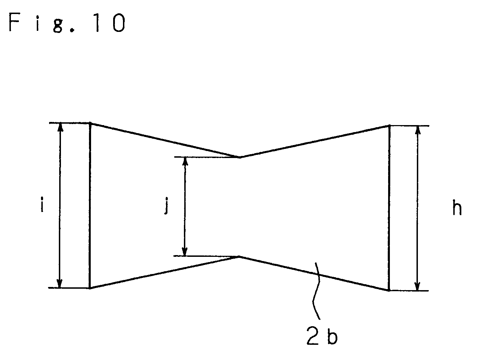

Fig.9 is an enlarged oblique view drawing illustrative of further another pattern (fourth embodiment) of the invention. Fig.10 is a side view drawing in A-A line of Fig.2. In Fig.9, the arrow shows the direction of liquid material flow in the pipe 4. In the fourth embodiment, although distance between the yoke end section 2b and the pipe 4 is constant, height of the yoke end section 2b is made to gradually decrease from the upstream to the center and gradually increase from the center to the downstream, so that the magnetic field has the minimum intensity at point h at the upstream end and point i at the downstream end, and increases therefrom toward the center, having a maximum intensity at point j at the center.

Because the intensity of the static magnetic field can be continuously swept within a certain range in any of the embodiments described above, static magnetic field having a proper intensity which satisfies the equation for chemical shift described previously can be always obtained at one point in the first and second embodiments and at two points in the third and fourth embodiments, so that nuclear magnetic resonance occurs certainly in the hydrogen nuclei included in the hydrocarbon liquid material flowing in the pipe 4. The hydrocarbon liquid material with enhanced dissociation through nuclear magnetic resonance is supplied through the pipe 4 to a downstream combustion system, thereby improving the combustion efficiency of the fuel and purifying the exhaust gas.

Although embodiments to improve the combustion efficiency of hydrocarbon liquid materials through nuclear magnetic resonance have been described, these are mere examples and it needs not to say that the apparatus of the invention can be applied to nuclear magnetic resonance of other purposes. It also needs not to say that the apparatus of the invention is not restricted to the nuclear magnetic resonance but can be applied to other forms of magnetic resonance such as electron spin resonance,

According to the invention, as described above, because the configuration of the end sections of the yoke are changed to form a static magnetic field generated in the open section of the magnetic path having gradient distribution of magnetic force, the invention provides excellent effects such as being capable of automatically deal with the chemical shift in the magnetic resonance thereby automatically carrying out stable magnetic resonance continuously in a simple constitution without using an expensive frequency conversion amplifier.

As this invention may be embodied in several forms without departing from the spirit of essential characteristics thereof, the present embodiment is therefore illustrative and not restrictive, since the scope of the invention is defined by the appended claims rather than by the description preceding them, and all changes that fall within metes and bounds of the claims, or equivalence of such metes and bounds thereof are therefore intended to be embraced by the claims.

**Claims**

1. A magnetic field sweeping apparatus to deal with chemical shift during magnetic resonance of a moving object material, wherein a static magnetic field is formed in an open section (3) of the magnetic path through which the object material passes so that the magnetic force has a gradient distribution.

2. A magnetic field sweeping apparatus of claim 1 wherein gradient configuration of the magnetic force of the static magnetic field is made to gradually open from the upstream of the movement of the object material to the downstream.

3. A magnetic field sweeping apparatus of claim 1 wherein gradient configuration of the magnetic force of the static magnetic field is made to gradually close from the upstream of the movement of the object material to the downstream.

4. A magnetic field sweeping apparatus of claim 1 wherein gradient configuration of the magnetic force of the static magnetic field is made to gradually open from the upstream of the movement of the object material toward the center reaching the maximum value at the center, and to gradually close from the center to the downstream.

5. A magnetic field sweeping apparatus of claims 1, 2, 3 or 4 wherein gradient configuration of the magnetic force of the static magnetic field is formed by changing the distance of the open section (3) of the magnetic path along the direction of the movement of the object material.

6. A magnetic field sweeping apparatus of claim 1, 2, 3 or 4 wherein gradient configuration of the magnetic force of the static magnetic field is formed by changing the thickness of a magnetic circuit (2b) which forms the magnetic path along the direction of the movement of the object material.

7. A magnetic resonance apparatus to cause magnetic resonance of a moving object material, comprising magnetic field forming means (1, 2) for forming a static magnetic field with the intensity changing in the direction of the movement of the object material and means (5, 6) for applying a high frequency electromagnetic field of a constant frequency to the object material.

8. A magnetic resonance apparatus of claim 7 wherein the magnetic field forming means includes the magnetic field sweeping apparatus of claim 1, 2, 3, 4, 5 or 6.

9. A magnetic resonance apparatus of claim 7 wherein the magnetic resonance is a form of magnetic resonance selected from among a group consisting of nuclear magnetic resonance and electron spin resonance.

**10.** A magnetic resonance apparatus of claim 7 wherein the object material is a liquid material composed of a hydrogen compound.

Fig. 1

LIQUID
MATERIAL

Fig. 2

Fig. 3

LIQUID
MATERIAL

2 b

4

3

2 b

F i g. 4

b

a

2 b

Fig. 5

LIQUID
MATERIAL

Fig. 6

Fig. 7

LIQUID
MATERIAL

Fig. 8

Fig. 9

LIQUID
MATERIAL

Fig.10

2 b

## DOCUMENTS CONSIDERED TO BE RELEVANT

| Category | Citation of document with indication, where appropriate, of relevant passages | Relevant to claim | CLASSIFICATION OF THE APPLICATION (Int.Cl.6) |
|---|---|---|---|
| X | US-A-4 629 987 (J.D. KING ET AL.)<br>* column 1, line 13 - line 40 *<br>* column 8, line 29 - line 64; figure 3 * | 7-10 | G01R33/383<br>G01R33/44 |
| Y | | 1-3 | |
| Y | US-A-4 654 593 (J.L. ACKERMAN)<br>* abstract *<br>* column 1, line 23 - column 3, line 46 * | 1-3 | |
| X | WO-A-84 04397 (SOUTHWEST RESEARCH INSTITUTE)<br>* page 2, line 12 - page 4, line 24; figures 1,6 * | 7-10 | |
| A | | 1-3 | |
| X | DE-A-41 19 711 (A. BAYER)<br>* column 1, line 3 - column 3, line 12; figure 2 * | 7,8,10 | |
| A | | 1-5,9 | |
| X | WO-A-93 14413 (OXFORD INSTRUMENTS LIMITED)<br>* page 5, line 19 - page 6, line 23; figures 2-5,9-11 * | 7,8,10 | **TECHNICAL FIELDS SEARCHED** (Int.Cl.6)<br><br>G01R<br>G01F |
| A | | 1-5,9 | |
| X | US-A-3 473 108 (W.S. MCCORMICK)<br>* column 6, line 3 - line 63; figure 1 * | 7,8,10 | |
| A | | 1-3 | |
| X,P | WO-A-93 19475 (OXFORD INSTRUMENTS LIMITED)<br>* page 5, line 4 - page 6, line 28; figures 2,3,5A * | 7,8,10 | |
| A,P | | 1-3 | |

The present search report has been drawn up for all claims

| Place of search | Date of completion of the search | Examiner |
|---|---|---|
| THE HAGUE | 9 January 1995 | Horak, G |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)